# EUROPÄISCHE PATENTSCHRIFT

(11) **EP 0 838 858 B1**
(45) Veröffentlichungstag und Bekanntmachung des Hinweises auf die Patenterteilung: **15.05.2002**
(21) Anmeldenummer: 97113774.0
(22) Anmeldetag: 08.08.1997
(51) Int. Cl.: H01L 27/092, H01L 27/12, H01L 21/86, H01L 21/84

(54) **Integrierte CMOS-Schaltungsanordnung und Verfahren zu deren Herstellung**
CMOS integrated circuit and method of manufacturing the same
Circuit intégré CMOS et son procéde de fabrication

(30) Priorität: 27.09.1996 DE 19639874
(43) Veröffentlichungstag der Anmeldung: 29.04.1998
(73) Patentinhaber: Infineon Technologies AG, 81669 München (DE)
(72) Erfinder: Lustig, Bernhard, Dr., 81737 München (DE); Schäfer, Herbert, Dr., 85635 Höhenkirchen-Siegertsbr. (DE); Franosch, Martin, 81739 München (DE)
(74) Vertreter: Müller . Hoffmann & Partner Patentanwälte

(56) Entgegenhaltungen:
- EP-A- 0 469 790
- EP-A- 0 480 446
- EP-A- 0 587 520
- EP-A- 0 651 439
- EP-A- 0 683 522
- JP-A- 7 142 742
- K. RIM: "ENHANCED HOLE MOBILITIES IN SURFACE-CHANNEL STRAINED-Si p-MOSFETs" PROCEEDINGS OF THE 1995 INTERNATIONAL ELECTRON DEVICES MEETING, IEDM'95, 10. - 13.Dezember 1995, WASHINGTON, Seiten 517-520, XP002073202
- "PLANAR FULLY-INTEGRATED BULK/SOI SIGE CMOS FABRICATION PROCESS" IBM TECHNICAL DISCLOSURE BULLETIN, Bd. 34, Nr. 10A, 1.März 1992, Seiten 128-129, XP000302251
- FITZGERALD E A: "THE EFFECT OF SUBSTRATE GROWTH AREA ON MISFIT AND THREADING DISLOCATION DENSITIES IN MISMATCHED HETEROSTRUCTURES" JOURNAL OF VACUUM SCIENCE AND TECHNOLOGY: PART B, Bd. 7, Nr. 4, 1.Juli 1989, Seiten 782-788, XP000168938
- NAYAK D K ET AL: "HIGH-MOBILITY GESI PMOS ON SIMOX" IEEE ELECTRON DEVICE LETTERS, Bd. 14, Nr. 11, 1.November 1993, Seiten 520-522, XP000418568

## Beschreibung

Integrierte CMOS-Schaltungsanordnung und Verfahren zu deren Herstellung.

Bei Strukturverkleinerungen in der MOS-Technik nach dem Prinzip der ähnlichen Verkleinerung bleiben im Mikrometerbereich die Eigenschaften von MOS-Transistoren und CMOS-Schaltungen im wesentlichen erhalten. Bei MOS-Transistoren mit Kanallängen von zum Beispiel unter 100 nm treten jedoch Kurzkanalund Puncheffekte auf.

Diese können zwar teilweise durch eine erhöhte Dotierung des Substrats ausgeglichen werden, eine derartige hohe Dotierung des Substrats führt jedoch unter anderem zu einer Verschlechterung der Ladungsträgerbeweglichkeit im Kanal.

Ferner muß bei MOS-Transistoren mit Kanallängen unter 100 nm die Unterschwellsteilheit d ln(I_{drain})/d V_{gate} maximiert werden, damit auch bei niedrigen Betriebsspannungen die Ströme im leitenden Zustand und im nichtleitenden Zustand des Transistors deutlich unterschieden werden können. Schließlich müssen, um extreme Kurzkanaleffekte zu vermeiden, flache Source/Drain-Gebiete eingesetzt werden, die einen kleinen spezifischen Serienwiderstand von der Größenordnung 100 Ωµm aufweisen.

JP-A-7 142 742 offenbart eine CMOS GeSi Anordnung mit Inseln.

In der Literatur (siehe zum Beispiel K. Rim et al, IEEE IEDM Tech. Dig., Seite 517 (1995)) ist vorgeschlagen worden, zur Vergrößerung der Ladungsträgerbeweglichkeit n- und p-Kanal-Transistoren in Substraten zu realisieren, die mindestens im Kanalbereich der Transistoren verspanntes Silizium aufweisen. Unter verspanntem Silizium wird dabei Silizium verstanden, dessen Gitterkonstante gegenüber dem ungestörten Siliziumkristall in zwei Raumrichtungen vergrößert ist.

Derartiges verspanntes Silizium wird dadurch hergestellt, daß Silizium auf einem Substrat mit größerer Gitterkonstante gitterangepaßt aufgewachsen wird. Als Substratmaterial ist Si₁₋ ₓGeₓ geeignet. Ein Problem bei der Herstellung von verspanntem Silizium sind die hohen Defektdichten in der Si₁₋ₓGeₓ-Unterlage.

Es ist vorgeschlagen worden (siehe A. R. Powell et al, Appl. Phys. Lett. 64, Seite 1856 (1994)), die Si₁₋ₓGeₓ-Schicht auf die gedünnte Siliziumschicht eines SOI-Substrates aufzuwachsen. Spannungen in der Si₁₋ₓGeₓ-Schicht relaxieren in diesem Fall in die darunterliegende gedünnte Siliziumschicht, sofern der Germaniumanteil in der Si₁₋ₓGeₓ-Schicht unter 15 Prozent liegt.

Zur Herstellung sehr flacher Source/Drain-Gebiete mit geringem Serienwiderstand ist von Y. Mitani et al, IEEE VLSI Tech. Dig., Seite 91 (1996), vorgeschlagen worden, die Source/Drain-Gebiete durch Ätzen von Vertiefungen in die Oberfläche des Substrats und selektives, in situ dotiertes Aufwachsen von amorphem Silizium und anschließendes Rekristallisieren des amorphen Siliziums herzustellen.

Der Erfindung liegt das Problem zugrunde, eine integrierte CMOS-Schaltungsanordnung und ein Verfahren zu deren Herstellung anzugeben, in der Kurzkanaleffekte und Puncheffekte vermieden werden und eine hohe Ladungsträgerbeweglichkeit sichergestellt wird.

Dieses Problem wird erfindungsgemäß gelöst durch eine CMOS-Schaltungsanordnung gemäß Anspruch 1 sowie ein Verfahren zu deren Herstellung gemäß Anspruch 6. Weitere Ausgestaltungen der Erfindung gehen aus den Unteransprüchen hervor.

In der erfindungsgemäßen CMOS-Schaltungsanordnung sind die Transistoren in Halbleiterinseln angeordnet, die auf einer isolierenden Schicht angeordnet sind. Jede der Halbleiterinseln umfaßt eine Si₁₋ₓGeₓ-Schicht und eine darauf angeordnete verspannte Siliziumschicht. Die Si₁₋ₓGeₓ-Schicht kann von der isolierenden Schicht durch eine Siliziumschicht getrennt sein. Die verspannte Siliziumschicht weist im wesentlichen die gleiche Gitterkonstante wie die Si₁₋ₓGeₓ-Schicht auf. In jeder Halbleiterinsel können mechanische Spannungen der Si₁₋ ₓGeₓ-Schicht gegebenenfalls über die darunter angeordnete Siliziumschicht, oder durch das gegebenenfalls zum Beispiel thermisch aufgeweichte Isolationsmaterial zu den Seiten der Halbleiterinseln relaxieren. Daher weist die Si₁₋ₓGeₓ-Schicht auch bei Germaniumanteilen über 40 Prozent praktisch keine Defekte auf. Die Verwendung von Si₁₋ₓGeₓ-Schichten mit Germaniumanteilen über zum Beispiel 15 Prozent hat den Vorteil, daß in der darauf verspannten Siliziumschicht wesentlich höhere Elektronen- und Löcherbeweglichkeiten erhalten werden.

Bei einem Germaniumanteil von zum Beispiel 40 Prozent kann die Dicke der Siliziumschicht zum Beispiel 10 nm, der Si₁₋ ₓGeₓ-Schicht 20 nm und der verspannten Siliziumschicht 10 nm betragen. Es liegt im Rahmen der Erfindung, die Siliziumschicht im Dickenbereich zwischen 0 nm und ca. 20 nm, die Si₁₋ₓGeₓ-Schicht im Dickenbereich zwischen 10 nm und 50 nm und mit Germaniumanteilen von 20 Prozent bis 50 Prozent und die verspannte Siliziumschicht im Dickenbereich zwischen 5 nm und 20 nm herzustellen.

In dem MOS-Transistor bildet sich im leitenden Zustand sowohl für n-Kanal- als auch für p-Kanal-Transistoren ein leitender Kanal an der Oberfläche der verspannten Siliziumschicht aus.

Um die Ausbildung vergrabener Kanäle an der Grenzfläche zwischen der Si₁₋ₓGeₓ-Schicht und der verspannten Siliziumschicht zu vermeiden, liegt es im Rahmen der Erfindung, zwischen der Si₁₋ₓGeₓ-Schicht und der verspannten Siliziumschicht eine Pufferschicht vorzusehen, die Si_{1-y}Ge_{y} enthält mit y ≤ x und in der der Germaniumanteil abnimmt. Die Pufferschicht weist den geringsten Germaniumanteil an der Grenzfläche zur verspannten Siliziumschicht auf.

Zur Realisierung einer symmetrischen CMOS-Schaltungsanordnung, in der die Schwellenspannung von n-Kanal-Transistoren gleich der Schwellenspannung der p-Kanal-Transistoren ist, ist es vorteilhaft, die MOS-Transistoren mit Gateelektroden zu versehen, die polykristallines, p⁺-dotiertes Germanium enthalten. Die Gateelektroden können aus reinem polykristallinem Germanium oder aus einer Mischung aus polykristallinem SiₓGe₁₋ₓ bestehen. Polykristallines, p⁺-dotiertes Germanium weist eine Austrittsenergie auf, die im wesentlichen in der Mitte der Bandlücke von verspanntem Silizium liegt. Es lassen sich damit sowohl n- als auch p-Oberflächenkanal-MOS-Transistoren mit exzellenten Kennlinien realisieren.

Die Herstellung der Halbleiterinseln erfolgt vorzugsweise ausgehend von einem SOI-Substrat, das eine Siliziumschicht und eine darunter angeordnete isolierende Schicht auf einer Trägerscheibe umfaßt. Die Siliziumschicht wird inselförmig strukturiert, wobei die Oberfläche der isolierenden Schicht teilweise freigelegt wird. Die Si₁₋ₓGeₓ-Schicht kann sowohl durch selektive Epitaxie auf der strukturierten Siliziumschicht, als auch durch Einbringen von Germanium durch Implantation oder Diffusion in die strukturierte Siliziumschicht gebildet werden. Im Hinblick auf eine definierte Schichtdicke ist die selektive Epitaxie vorteilhaft.

Die verspannte Siliziumschicht wird anschließend durch selektive Epitaxie aufgewachsen. Beim epitaktischen Aufwachsen wird in der verspannten Siliziumschicht die Gitterkonstante aus der Si₁₋ₓGeₓ-Schicht übernommen.

Im Hinblick auf flache Source/Drain-Gebiete ist es vorteilhaft, die Source/Drain-Gebiete jeweils aus einem ersten Teilgebiet und einem zweiten Teilgebiet zu bilden. Das zweite Teilgebiet weist dabei eine geringere Tiefe und Dotierstoffkonzentration als das erste Teilgebiet auf. Die effektive Kanallänge wird durch den lateralen Abstand der zweiten Teilgebiete bestimmt. In der Literatur sind für die ersten Teilgebiete der Begriff HDD-Profil und für die zweiten Teilgebiete der Begriff LDD-Profil gebräuchlich.

Es ist vorteilhaft, zunächst die ersten Teilgebiete herzustellen, wobei Spacer an den Flanken der Gateelektrode den Abstand der ersten Teilgebiete zur Gateelektrodenkante definieren. Nach Entfernen dieser Spacer werden anschließend die zweiten Teilgebiete der Source/Drain-Gebiete erzeugt. Da die zweiten Teilgebiete nach den ersten Teilgebieten gebildet werden, sind sie den Temperaturbelastungen und den Prozeßschritten zur Bildung der ersten Teilgebiete nicht unterworfen und können daher mit einem steileren Dotierstoffprofil hergestellt werden.

Vorzugsweise werden die zweiten Teilgebiete für die Source/Drain-Gebiete für die p-Kanal-Transistoren durch Ätzen mindestens in die verspannte Siliziumschicht und anschließende selektive in situ dotierte Epitaxie gebildet. Bei der in situ dotierten Epitaxie wird der Dotierstoff in das epitaktisch gewachsene Kristallgebiet eingebaut. Eine nachfolgende Aktivierung des Dotierstoffs ist bei der in situ dotierten Epitaxie nicht erforderlich. Damit können stufenförmige Dotierstoffprofile gebildet werden.

Im folgenden wird die Erfindung anhand eines Ausführungsbeispiels, das in den Figuren dargestellt ist, näher erläutert.
- Figur 1: zeigt ein Substrat mit einer Halbleiterinsel.
- Figur 2: zeigt das Substrat nach Bildung von Wannen zur Aufnahme von komplementären MOS-Transistoren in der Halbleiterinsel, nach Bildung von Gatedielektrikum, Gateelektrode, Seitenwandspacern und Abscheidung einer ersten Hilfsschicht und einer zweiten Hilfsschicht.
- Figur 3: zeigt das Substrat nach Bildung von Spacern aus der zweiten Hilfsschicht und Bildung von ersten Teilgebieten für die Source/Drain-Gebiete des n-Kanal-Transistors.
- Figur 4: zeigt das Substrat nach Bildung von ersten Teilgebieten für die Source/Drain-Gebiete der p-Kanal-Transistoren.
- Figur 5: zeigt das Substrat nach Entfernen der Spacer und Bildung von zweiten Teilgebieten für die Source/Drain-Gebiete der n-Kanal-Transistoren.
- Figur 6: zeigt das Substrat nach einer Ätzung in die Halbleiterinsel im Bereich des p-Kanal-Transistors.
- Figur 7: zeigt das Substrat nach Bildung von zweiten Teilgebieten der Source/Drain-Gebiete für den p-Kanal-Transistor durch selektive in situ dotierte Epitaxie.
- Figur 8: zeigt das Substrat nach selektivem Aufwachsen von Silizium.
- Figur 9: zeigt das Substrat nach Bildung von Silizidschichten an der Oberfläche der Source/Drain-Gebiete und der Gateelektroden.

Die Darstellungen in den Figuren sind nicht maßstabsgerecht.

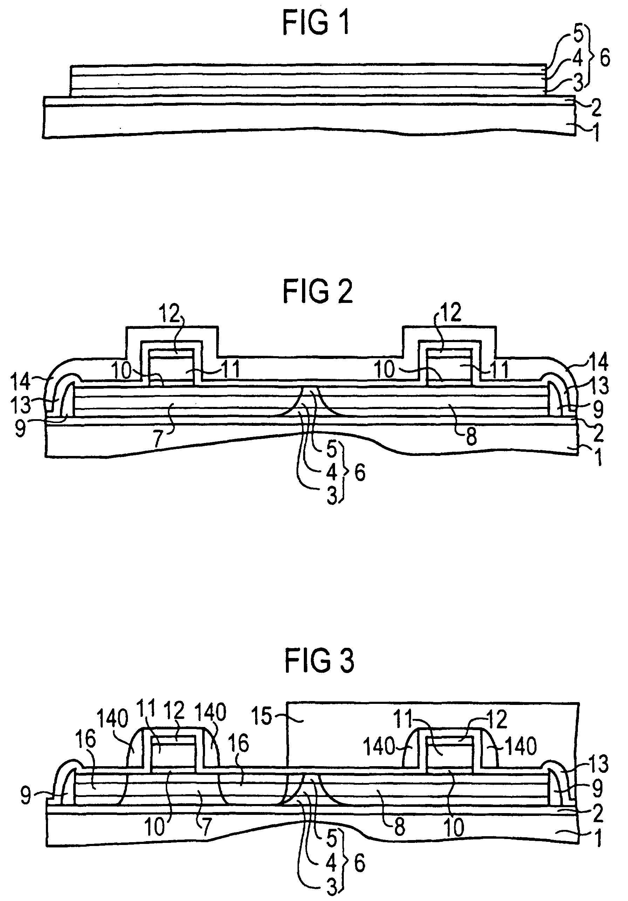

Auf einer Trägerplatte 1 aus zum Beispiel Silizium oder Saphir ist eine isolierende Schicht 2 aus zum Beispiel SiO₂ mit einer Schichtdicke von zum Beispiel 400 nm angeordnet. Auf der isolierenden Schicht 2 ist eine strukturierte Siliziumschicht 3 mit einer Schichtdicke von zum Beispiel 0 bis 10 nm, eine Si₁₋ₓGeₓ-Schicht 4 mit einer Schichtdicke von zum Beispiel 15 nm und einem Germaniumanteil von zum Beispiel 35 Prozent und eine verspannte Siliziumschicht 5 mit einer Schichtdicke von zum Beispiel 5 nm angeordnet. Die strukturierte Siliziumschicht 3, die Si₁₋ₓGeₓ-Schicht 4 und die verspannte Siliziumschicht 5 bilden gemeinsam eine Halbleiterinsel 6 (siehe Figur 1).

Zur Herstellung der Halbleiterinsel 6 wird vorzugsweise ein SOI-Substrat verwendet, das die Trägerplatte 1 aus Silizium und die isolierende Schicht 2 aus SiO₂ und eine darauf angeordnete monokristalline Siliziumschicht umfaßt. Zunächst wird die monokristalline Siliziumschicht auf die gewünschte Dicke reduziert, zum Beispiel durch Oxidation und Ätzen mit zum Beispiel HF. Anschließend wird mit Hilfe photolithographischer Prozeßschritte die strukturierte Siliziumschicht 3 gebildet. Die Si₁₋ₓGeₓ-Schicht 4 wird durch selektive Epitaxie unter Verwendung von H₂, SiH₂Cl₂, GeH₄ als Prozeßgas im Temperaturbereich zwischen 500°C und 900°C und Druckbereich zwischen 1 und 760 Torr aufgewachsen. In der Si₁₋ₓGeₓ-Schicht auftretende mechanische Verspannungen relaxieren in die strukturierte Siliziumschicht 3 über die freiliegenden Seitenflächen. Die bei der selektiven Epitaxie gebildete Si₁₋ ₓGeₓ-Schicht 4 ist annähernd frei von mechanischen Spannungen. Die verspannte Siliziumschicht 5 wird ebenfalls durch selektive Epitaxie aufgewachsen. Dabei wird als Prozeßgas H₂, SiH₂Cl₂ verwendet. Die Prozeßtemperatur liegt zwischen 600°C und 800°C, der Druck zwischen 1 und 760 Torr (1 Torr = 133,3 Newtons/m²).

Die Halbleiterinsel 6 weist parallel zur Oberfläche der isolierenden Schicht 2 Abmessungen von zum Beispiel 2 µm x 5 µm auf.

Durch Änderung der Prozeßgaszusammensetzung bei der selektiven Epitaxie zur Herstellung der Si₁₋ₓGeₓ-Schicht entsteht an der Grenzfläche zur verspannten Siliziumschicht 5 eine Pufferschicht aus Si_{1-y}Ge_{y}, in der der Germaniumanteil stetig abnimmt. Der Übersichtlichkeit halber ist die Pufferschicht in Figur 1 nicht dargestellt. Die Pufferschicht weist eine Dicke von zum Beispiel 10 nm auf. Der Germaniumanteil y beträgt zum Beispiel 35 Prozent bis 0 Prozent.

Zur Herstellung eines n-Kanal-Transistors und eines p-Kanal-Transistors in der Halbleiterinsel 6 wird zunächst eine Streuoxidschicht aus TEOS-SiO₂ in einer Dicke von 20 nm abgeschieden (nicht dargestellt). Durch maskierte Implantation wird eine p-dotierte Wanne 7 für den n-Kanal-Transistor und eine n-dotierte Wanne 8 für den p-Kanal-Transistor gebildet (siehe Figur 2). Die Implantation der p-dotierten Wanne 7 erfolgt zum Beispiel mit Bor mit einer Dosis von 2 x 10¹² cm⁻² bei 7 keV. Die Implantation zur Bildung der n-dotierten Wanne 8 erfolgt zum Beispiel mit Phosphor mit einer Dosis von 3 x 10¹² cm⁻² bei 15 keV.

Danach werden photolithographisch die endgültigen, vertikalen Inselkanten definiert und anisotrop mit zum Beispiel CHF₃/CF₄ (Streuoxid), bzw. HBr (Si/SiGe-Stack) geätzt (Ätzstop ist die isolierende Schicht 2). Nach eventueller Passivierung der Seitenwände der Halbleiterinsel werden dort Seitenwandspacer 9 zum Beispiel aus Si₃N₄ gebildet und die Streuoxidschicht entfernt (siehe Figur 2).

Zur Bildung von Gatedielektrikum 10, Gateelektrode 11 und Deckschicht 12 für den n-Kanal-Transistor und den p-Kanal-Transistor wird anschließend eine zum Beispiel 3 nm dicke SiO₂-Schicht durch Plasmaabscheidung oder durch thermische Oxidation bei 600°C, eine polykristalline Gateelektrodenschicht aus zum Beispiel polykristallinem Germanium oder polykristallinem Si₁₋ₓGe₁₋ₓ mit x gleich 0,15 und eine Deckschicht aus SiO₂ in einer Dicke von zum Beispiel 200 nm abgeschieden und anschließend mit Hilfe photolithographischer Prozeßschritte und anisotropem Ätzen, zum Beispiel mit HBr, strukturiert. Alternativ kann die Gateelektrode 11 mit Hilfe von Elektronenstrahllithographie oder mit Hilfe von Spacertechniken strukturiert werden. Die Gatelänge beträgt zum Beispiel 100 nm.

Es wird ganzflächig eine erste Hilfsschicht 13 aus zum Beispiel TEOS-SiO₂ oder Si₃N₄ in einer Schichtdicke von zum Beispiel 10 nm mit im wesentlichen konformer Kantenbedeckung abgeschieden. Darauf wird eine zweite Hilfsschicht 14 aus zum Beispiel Polysilizium mit einer Schichtdicke von zum Beispiel 60 nm abgeschieden. Die zweite Hilfsschicht 14 ist selektiv zur ersten Hilfsschicht 13 ätzbar.

Durch anisotropes Ätzen der zweiten Hilfsschicht 14 selektiv zur ersten Hilfsschicht 13 mit zum Beispiel HBr werden im Bereich der Flanken der Gateelektroden 11 Spacer 140 gebildet (siehe Figur 3). Es wird eine erste Maske 15 aus zum Beispiel Photolack gebildet, die die n-dotierte Wanne 8 abdeckt. Zur Bildung erster Teilgebiete 16 der Source/Drain-Gebiete für den n-Kanal-Transistor wird eine Implantation mit Arsen mit einer Dosis von 2 x 10¹⁵ cm⁻² bei einer Energie von 30 keV durchgeführt. Anschließend wird die erste Maske 15 entfernt und ein Temperschritt durchgeführt zur Ausheilung von Implantationsschäden und zum Eintreiben und Aktivieren des Dotierstoffes in den ersten Teilgebieten 16 des n-Kanal-Transistors. Der Temperschritt wird bei zum Beispiel 800°C 60 Sekunden durchgeführt.

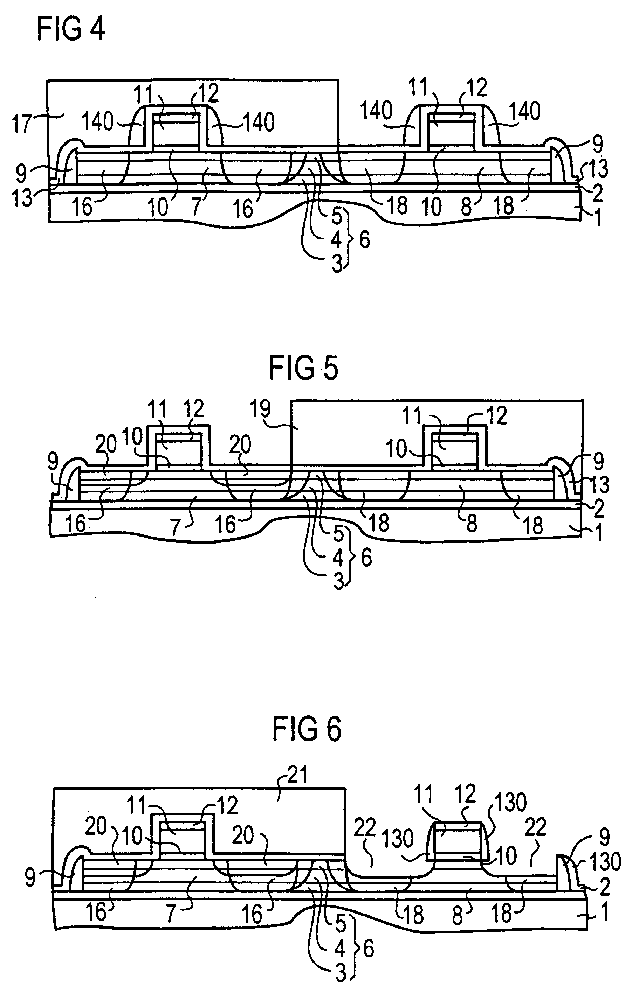

Es wird eine zweite Maske 17 erzeugt, die die p-dotierte Wanne 7 abdeckt. Durch Implantation mit Bor bei 2 x 10¹⁵ cm⁻² und 10 keV werden erste Teilgebiete 18 der Source/Drain-Gebiete für den p-Kanal-Transistor gebildet (siehe Figur 4). Durch Verwenden einer etwas höheren Energie bei der Implantation zur Bildung der ersten Teilgebiete 16 für den n-Kanal-Transistor und der ersten Teilgebiete 18 für den p-Kanal-Transistor können entstehende mechanische Verspannungen besser abgeleitet werden, da bei höherer Energie und Dosis der Implantation die isolierende Schicht 2 aufgeweicht wird und ein Gleiten der Halbleiterinsel 6 zum Abbau mechanischer Spannungen erleichtert wird.

Die zweite Maske 17 wird entfernt. Die Spacer 140 werden durch naßchemisches Ätzen zum Beispiel mit Cholin selektiv zur ersten Hilfsschicht 13 entfernt (siehe Figur 5).

Es wird eine dritte Maske 19 zum Beispiel aus Photolack gebildet, die die n-dotierte Wanne 8 abdeckt. Durch Implantation mit Arsen mit 2 x 10¹⁴ cm⁻² bei 10 keV werden zweite Teilgebiete 20 der Source/Drain-Gebiete für den n-Kanal-Transistor gebildet (siehe Figur 5). Die Tiefe und die Dotierstoffkonzentration der zweiten Teilgebiete 20 der Source/Drain-Gebiete ist geringer als für die ersten Teilgebiete 16. Die laterale Abmessung der zweiten Teilgebiete 20 ist jedoch größer als die der ersten Teilgebiete 16, da zuvor die Spacer 140 entfernt wurden.

Nach Entfernen der dritten Maske 19 wird ein gemeinsamer Temperschritt durchgeführt, um Implantationsschäden bei der Bildung der ersten Teilgebiete 18 für den p-Kanal-Transistor und der zweiten Teilgebiete 20 für den n-Kanal-Transistor auszuheilen und den Dotierstoff in diesen Gebieten einzutreiben und zu aktivieren. Der Temperschritt erfolgt zum Beispiel bei 750°C, 30 Sekunden. Bei diesen Temperbedingungen wird ein Auseinanderlaufen des Dotierstoffprofils insbesondere im zweiten Teilgebiet 20 für den n-Kanal-Transistor vermieden.

Es wird eine vierte Maske 21 aus zum Beispiel Photolack gebildet, die die p-dotierte Wanne 7 abdeckt. Durch anisotropes Ätzen zum Beispiel mit einem anisotropen CHF₃- und CF₄-Ätzprozeß wird im Bereich für den p-Kanal-Transistor die erste Hilfsschicht 13 geätzt, wobei aus der ersten Hilfsschicht 13 Spacer 130 an den Flanken der Gateelektrode 11 entstehen (siehe Figur 6).

Durch eine Ätzung, die Silizium selektiv zu den Spacern 130 angreift, werden im Bereich für den p-Kanal-Transistor seitlich der Gateelektrode 6 Vertiefungen 22 gebildet. Die Ätzung erfolgt vorzugsweise isotrop, so daß sich die Vertiefungen auch unter die Spacer 130 erstrecken. Die Vertiefungen 22 weisen eine Tiefe von zum Beispiel 15 nm auf. Sie reichen bis in die Si₁₋ₓGeₓ-Schicht 4 hinein. Bei der Ätzung der Vertiefungen 22 ist es vorteilhaft, ein Germaniumsignal aus der Si₁₋ₓGeₓ-Schicht 4 als Stopsignal zu verwenden. Die Ätzung erfolgt zum Beispiel naßchemisch mit Cholin.

Nach Entfernen der vierten Maske 21, und einer Naßreinigung der im Bereich der Vertiefungen 22 freigelegten kristallinen Oberflächen zum Beispiel durch einen HF-Dip werden die Vertiefungen 22 durch selektive, in situ dotierte epitaktische Abscheidung mit zweiten Teilgebieten 23 der Source/Drain-Gebiete für den p-Kanal-Transistor aufgefüllt. Dabei ist es vorteilhaft, vor der epitaktischen Abscheidung durch geringe Zugabe von GeH₄ oder SiH₄ bei 750°C in situ eine Niedertemperaturreinigung der Oberflächen durchzuführen, bei der das natürliche Oxid von Si-Oberflächen abgeätzt wird.

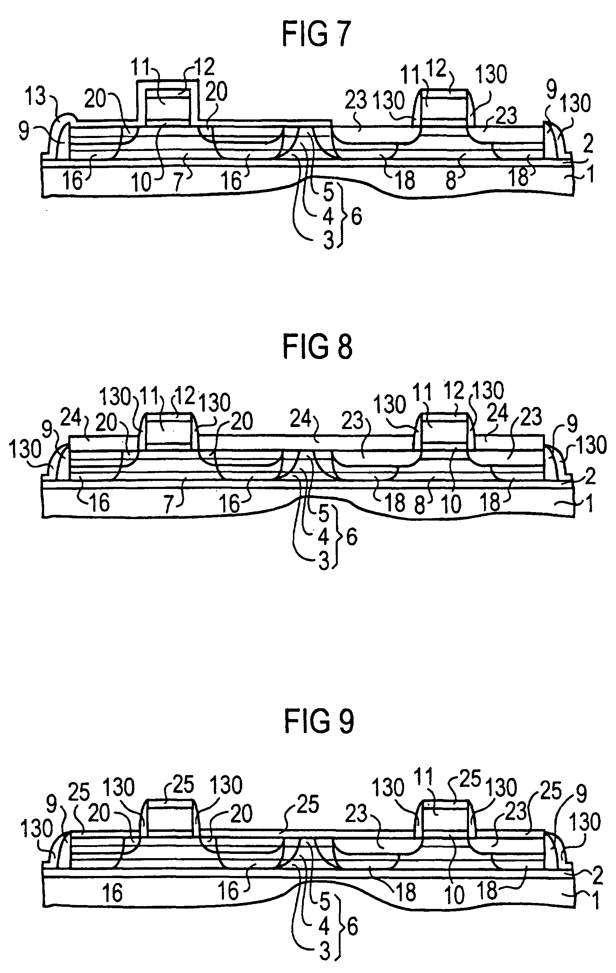

Die in situ dotierte, selektive epitaktische Siliziumabscheidung erfolgt zum Beispiel unter Verwendung eines Gasgemisches aus H₂, SiH₂Cl₂, HCl und B₂H₆ bei 750°C und 10 Torr. Die Prozeßtemperatur wird dabei so gewählt, daß die Struktur und Zusammensetzung der strukturierten Siliziumschicht 3, der Si₁₋ ₓGeₓ-Schicht 4 und der verspannten Siliziumschicht unverändert bleiben. Durch die Zugabe von B₂H₆ zu dem Prozeßgasgemisch wird in guter Näherung ein stufenförmiges Dotierprofil für die zweiten Teilgebiete 23 erzeugt. Der Dotierstoff wird in den zweiten Teilgebieten 23 durch die in situ dotierte Epitaxie in das Kristallgitter eingebaut, so daß kein Temperschritt zur Aktivierung der Dotierstoffe erforderlich ist. Das bei der selektiven Epitaxie erzeugte stufenförmige Dotierprofil definiert daher die Ausdehnung der zweiten Teilgebiete 23 für den p-Kanal-Transistor. Die zweiten Teilgebiete 23 für den p-Kanal-Transistor weisen eine Tiefe von zum Beispiel 15 nm auf (siehe Figur 7).

Danach wird auch im Bereich des n-Kanal-Transistors eine Spacerätzung zum Beispiel mit einem anisotropen CHF₃- und CF₄-Ätzprozeß durchgeführt, bei dem die erste Hilfsschicht 13 geätzt wird und an den Flanken der Gateelektrode 6 Spacer 130 entstehen. Bei der Spacerätzung im Bereich des n-Kanal-Transistors kann der Bereich des p-Kanal-Transistors mit einer weiteren Maske, die nicht dargestellt ist, abgedeckt werden.

Anschließend werden durch selektive Epitaxie freiliegende Siliziumoberflächen mit einer Si_{1-z}Ge_{z}-Schicht 24 versehen. Die Si_{1-z}Ge_{z}-Schicht 24 wird undotiert aufgewachsen. Dazu wird zunächst eine Naßreinigung zum Beispiel mit einem HF-Dip und eine Niedertemperaturreinigung bei zum Beispiel 750°C durchgeführt. Die anschließende epitaktische Abscheidung von Si₁₋ _{z}Ge_{z} erfolgt zum Beispiel bei 650°C und 10 Torr mit einem Gasgemisch, das H₂, SiH₂Cl, HCl und GeH₄ enthält. Die Kristallzusammensetzung wird dabei so gewählt, daß die Gitterkonstante der Si_{1-z}Ge_{z}-Schicht 24 der Gitterkonstante der Si₁₋ₓGeₓ-Schicht 4 im wesentlichen gleicht, so daß kein weiterer Streß aufgebaut wird.

Nach Entfernen der Deckschicht 12 von den Gateelektroden 11 werden Silizidanschlüsse gebildet. Dazu wird zum Beispiel eine Titanschicht abgeschieden und ein Temperschritt zur Bildung der Titansilizidanschlüsse 25 durchgeführt. Bei der Bildung der Titansilizidanschlüsse 25 wird die Si_{1-z}Ge_{z}Schicht 24 vollständig aufgebraucht, so daß nirgendwo ungewollte pn-Übergänge entstehen. Die Titansilizidanschlüsse 24 entstehen sowohl an der Oberfläche der ersten Teilgebiete 16, 18 und zweiten Teilgebiete 20, 23 als auch auf der Oberfläche der Gateelektroden 11 und auf der freiliegenden Halbleiteroberfläche zwischen den benachbarten n-Kanal- und p-Kanal-Transistoren. Dadurch wird ein Source/Drain-Gebiet des p-Kanal-Transistors mit einem des n-Kanal-Transistors verbunden. Auf diese Weise wird selbstjustierend ein Inverter hergestellt.

Bei kurzen Kanallängen unter 150 nm liegt es im Rahmen der Erfindung, die Gateelektroden 11 mit T-förmigen Querschnitt herzustellen, um den Anschlußwiderstand der Gateelektroden 11 zu verbessern.

Die Seitenwandspacer 9 aus Si₃N₄ verhindern in diesem Beispiel die Ausbildung parasitärer MOS-Transistoren entlang der Seitenwände der Halbleiterinsel 6. Die Seitenwandspacer 9 können alternativ aus SiO₂ gebildet werden. Um in diesem Fall ein Freiätzen der Ecken der Halbleiterinsel 6 bei der Strukturierung des Gatedielektrikums 10 zu vermeiden, liegt es in diesem Fall im Rahmen der Erfindung, die Gateelektrode 11 aus mindestens zwei Schichten herzustellen, die nacheinander abgeschieden und strukturiert werden und wobei zwischen den beiden Schichten ein weiterer SiO₂-Spacer gebildet wird.

In dem Ausführungsbeispiel wird in der Halbleiterinsel ein p-Kanal-Transistor und ein n-Kanal-Transistor hergestellt, die als Inverter verschaltet sind. Selbstverständlich ist die Erfindung auch anwendbar auf Halbleiterinseln in denen nur ein Transistortyp, zum Beispiel n- oder p-Kanal-Transistoren oder nur ein einzelner Transistor vorgesehen ist.

Da die Halbleiterinseln 6 an der Oberfläche der isolierenden Schicht 2 angeordnet sind und die Kapazität der ersten Teilgebiete 16, 18 und zweiten Teilgebiete 20, 23 der Source/Drain-Gebiete zur Trägerplatte 1 umgekehrt proportional zur Dicke der isolierenden Schicht 2 ist, läßt sich diese Kapazität über die Dicke der isolierenden Schicht 2 einstellen. Weist die isolierende Schicht 2 eine Dicke von zum Beispiel 400 nm auf, so sind diese Kapazitäten vergleichbar mit denjenigen in einem MOS-Transistor in semiisolierendem GaAs. Damit werden in der erfindungsgemäßen CMOS-Schaltungsanordnung mit Si-MOS-Transistoren mit III-V-Halbleiter-Schaltungen vergleichbare Kapazitäten, annähernd ebenso gute Niederfeldbeweglichkeiten, aber gegenüber GaAs bessere Sättigungsdriftgeschwindigkeiten bei hohen Feldern erzielt. Bei Kanallängen unter 100 nm sollten aber die Sättigungseigenschaften einen größeren Einfluß auf die Schaltzeiten haben als die Niederfeldbeweglichkeiten.

## Patentansprüche

1. Integrierte CMOS-Schaltungsanordnung, bei der
- auf einer isolierenden Schicht (2), die auf einer Trägerplatte (1) angeordnet ist, Halbleiterinseln (6) angeordnet sind, die jeweils mindestens eine Si₁₋ₓGeₓ-Schicht (4) und eine Siliziumschicht (5) umfassen und
- eine Halbleiterinsel (6), ein p-Kanal-MOS-Transistor und ein n-Kanal-MOS-Transistor vorgesehen sind,
**dadurch gekennzeichnet, dass**
- in der mindestens einen Halbleiterinsel (6) mindestens der p-Kanal-MOS-Transistor und der n-Kanal-MOS-Transistor vorgesehen sind,
- der p-Kanal-MOS-Transistor in einer n-leitenden Wanne (8) und der n-Kanal-MOS-Transistor in einer neben der n-leitenden Wanne (8) angeordneten p-leitenden Wanne (7) liegen und
- die Siliziumschicht (5) eine durch selektiye Epitaxie auf der Si₁₋ₓGeₓ-Schicht (4) aufgewachsene verspannte Siliziumschicht ist, die im Wesentlichen die gleiche Gitterkonstante wie die Si₁₋ₓGeₓ-Schicht (4) aufweist.

2. CMOS-Schaltungsanordnung nach Anspruch 1,
**dadurch gekennzeichnet, dass**
zwischen der Si₁₋ₓGeₓ-Schicht (4) und der isolierenden Schicht (2) eine Siliziumschicht (3) angeordnet ist.

3. CMOS-Schaltungsanordnung nach Anspruch 2,
**dadurch gekennzeichnet, dass**
- die strukturierte Siliziumschicht (3) eine Dicke zwischen Onm und 20 nm aufweist,
- die Si₁₋ₓGeₓ-Schicht (4) eine Dicke zwischen 10 nm und 50 nm und einen Germaniumanteil von zwischen 20 Prozent und 50 Prozent aufweist, und
- die verspannte Siliziumschicht (5) eine Dicke zwischen 5 nm und 20 nm aufweist.

4. CMOS-Schaltungsanordnung nach einem der Ansprüche 1 bis 3,
**dadurch gekennzeichnet, dass**
zwischen der Si₁₋ₓGeₓ-Schicht (4) und der verspannten Siliziumschicht (5) eine Pufferschicht angeordnet ist, die Si_{1-y}Ge_{y} enthält und in der der Germaniumanteil abnimmt.

5. CMOS-Schaltungsanordnung nach einem der Ansprüche 1 bis 4,
**dadurch gekennzeichnet, dass**
die Gateelektroden (11) der MOS-Transistoren polykristallines Germanium enthalten.

6. Verfahren zur Herstellung einer integrierten CMOS-Schaltungsanordnung, bei dem:
- eine Siliziumschicht (3) eines SOI-Substrates, das die Siliziumschicht (3) und eine darunter angeordnete isolierende Schicht (2) auf einer Trägerplatte (1) umfasst, inselförmig strukturiert wird, wobei die Oberfläche der isolierenden Schicht (2) teilweise freigelegt wird, und
- zur Bildung von Halbleiterinseln (6) auf der strukturierten Siliziumschicht (3) eine Si₁₋ₓGeₓ-Schicht (4) und eine Siliziumschicht (5) gebildet wird,
**dadurch gekennzeichnet, dass**
- die verspannte Siliziumschicht (5) durch selektive Epitaxie auf die Si₁₋ₓGeₓ-Schicht (4) aufgewachsen wird,
- die Dicke der Si₁₋ₓGeₓ-Schicht (4) so auf die Dicke der strukturierten Siliziumschicht (3) abgestimmt wird, dass sich die Gitterkonstante der strukturierten Siliziumschicht (3) der Gitterkonstanten der Si₁₋ₓGeₓ-Schicht (4) anpasst,
- in einer Halbleiterinsel (6) eine p-leitende Wanne (7) und neben dieser eine n-leitende Wanne (8) gebildet werden und
- in der p-leitenden Wanne (7) ein n-Kanal-MOS-Transistor und in der n-leitenden Wanne (8) ein p-Kanal-MOS-Transistor gebildet werden.

7. Verfahren nach Anspruch 6,
**dadurch gekennzeichnet, dass**
- die strukturierte Siliziumschicht (3) in einer Dicke zwischen 5 nm und 20 nm gebildet wird,
- die Si₁₋ₓGeₓ-Schicht (4) mit einer Dicke zwischen 10 nm und 50 nm und einem Germaniumanteil x zwischen 20 Prozent und 50 Prozent gebildet wird, und
- die verspannte Siliziumschicht (5) in einer Dicke zwischen 5 nm und 20 nm gebildet wird.

8. Verfahren nach Anspruch 6 oder 7,
**dadurch gekennzeichnet, dass**
zur Bildung der Halbleiterinsel (6) durch selektive Epitaxie auf die strukturierte Siliziumschicht (3) die Si₁₋ₓGeₓ-Schicht (4) aufgewachsen wird.

9. Verfahren nach Anspruch 6 oder 7,
**dadurch gekennzeichnet, dass**
zur Bildung der Halbleiterinseln (6) in die strukturierte Siliziumschicht (3) zur Bildung der Si₁₋ₓGeₓ-Schicht (4) Germanium durch Implantation oder Diffusion eingebracht wird.

10. Verfahren nach einem der Ansprüche 6 bis 9,
**dadurch gekennzeichnet, dass**
zwischen der Si₁₋ₓGeₓ-Schicht (4) und der verspannten Siliziumschicht (5) durch selektive Epitaxie eine Pufferschicht aufgewachsen wird, die Si_{1-y}Ge_{y} mit y ≤ x enthält und in der der Germaniumanteil abnimmt.

11. Verfahren nach einem der Ansprüche 6 bis 10,
**dadurch gekennzeichnet, dass**
- zur Herstellung mindestens eines p-Kanal-MOS-Transistors und eines n-Kanal-MOS-Transistors auf der Oberfläche der Halbleiterinsel (6) Gatestapel gebildet werden, die jeweils ein Gatedielektrikum (10), eine Gateelektrode (11) und eine Deckschicht (12) umfassen,
- eine Hilfsschicht (13) mit im Wesentlichen konformer Kantenbedeckung abgeschieden wird,
- im Bereich der Flanken der Gatestapel Spacer (140) gebildet werden, die selektiv zur Hilfsschicht (13) ätzbar sind,
- jeweils durch maskierte Implantation erste Teilgebiete (16, 18) der Source/Drain-Gebiete für den n-Kanal-MOS-Transistor und den p-Kanal-MOS-Transistor gebildet werden,
- die Spacer (140) entfernt werden, und
- nacheinander zweite Teilgebiete (20, 23) der Source/Drain-Gebiete für den n-Kanal-MOS-Transistor und den p-Kanal-MOS-Transistor gebidet werden, während Tiefe und Dotierstoffkonzentration jeweils geringer als die der ersten Teilgebiete (16, 18) ist.

12. Verfahren nach Anspruch 11,
**dadurch gekennzeichnet, dass** mindestens die zweiten Teilgebiete (23) der Source/Drain-Gebiete für den p-Kanal-MOS-Transistor durch Ätzen mindestens in die verspannte Siliziumschicht (5) und selektive, in situ dotierte Epitaxie gebildet werden.

13. Verfahren nach einem der Ansprüche 6 bis 12,
**dadurch gekennzeichnet, dass**
die Gateelektroden (11) der MOS-Transistoren polykristallines Germanium umfassen.

## Claims

1. Integrated CMOS circuit arrangement, in which
- semiconductor islands (6) are arranged on an insulating layer (2) arranged on a carrier plate (1), the said semiconductor islands each comprising at least one Si₁₋ₓGeₓ layer (4) and a silicon layer (5), and
- a semiconductor island (6), a p-channel MOS transistor and an n-channel MOS transistor are provided,
**characterized in that**
- at least the p-channel MOS transistor and the n-channel MOS transistor are provided in the at least one semiconductor island (6),
- the p-channel MOS transistor is located in an n-conducting well (8) and the n-channel MOS transistor is located in a p-conducting well (7) arranged beside the n-conducting well (8), and
- the silicon layer (5) is a stressed silicon layer which is grown by selective epitaxy on the Si₁₋ₓGeₓ layer (4) and essentially has the same lattice constant as the Si₁₋ₓGeₓ layer (4).

2. CMOS circuit arrangement according to Claim 1,
**characterized in that**
a silicon layer (3) is arranged between the Si₁₋ₓGeₓ layer (4) and the insulating layer (2).

3. CMOS circuit arrangement according to Claim 2,
**characterized in that**
- the patterned silicon layer (3) has a thickness of between 0 nm and 20 nm,
- the Si₁₋ₓGeₓ layer (4) has a thickness of between 10 nm and 50 nm and a germanium portion of between 20 per cent and 50 per cent, and
- the stressed silicon layer (5) has a thickness of between 5 nm and 20 nm.

4. CMOS circuit arrangement according to one of Claims 1 to 3,
**characterized in that**
a buffer layer which contains Si_{1-y}Ge_{y} and in which the germanium proportion decreases is arranged between the Si₁₋ₓGeₓ layer (4) and the stressed silicon layer (5).

5. CMOS circuit arrangement according to one of Claims 1 to 4,
**characterized in that**
the gate electrodes (11) of the MOS transistors contain polycrystalline germanium.

6. Method for fabricating an integrated CMOS circuit arrangement, in which:
- a silicon layer (3) of an SOI substrate which comprises the silicon layer (3) and, arranged beneath the latter, an insulating layer (2) on a carrier plate (1) is patterned in island form, the surface of the insulating layer (2) being partly uncovered, and
- in order to form semiconductor islands (6) on the patterned silicon layer (3), an Si₁₋ₓGeₓ layer (4) and a silicon layer (5) are formed,
**characterized in that**
- the stressed silicon layer (5) is grown by selective epitaxy on the Si₁₋ₓGeₓ layer (4),
- the thickness of the Si₁₋ₓGeₓ layer (4) is coordinated with the thickness of the patterned silicon layer (3) in such a way that the lattice constant of the patterned silicon layer (3) matches the lattice constant of the Si₁₋ₓGeₓ layer (4),
- a p-conducting well (7) and, beside the latter, an n-conducting well (8) are formed in a semiconductor island (6), and
- an n-channel MOS transistor is formed in the p-conducting well (7) and a p-channel MOS transistor is formed in the n-conducting well (8).

7. Method according to Claim 6,
**characterized in that**
- the patterned silicon layer (3) is formed to a thickness of between 5 nm and 20 nm,
- the Si₁₋ₓGeₓ layer (4) is formed with a thickness of between 10 nm and 50 nm and a germanium proportion x of between 20 per cent and 50 per cent, and
- the stressed silicon layer (5) is formed to a thickness of between 5 nm and 20 nm.

8. Method according to Claim 6 or 7,
**characterized in that**
in order to form the semiconductor island (6), the Si₁₋ₓGeₓ layer (4) is grown by selective epitaxy on the patterned silicon layer (3).

9. Method according to Claim 6 or 7,
**characterized in that**
in order to form the semiconductor islands (6), germanium is introduced by implantation or diffusion into the patterned silicon layer (3) in order to form the Si₁₋ₓGeₓ layer (4).

10. Method according to one of Claims 6 to 9,
**characterized in that**
a buffer layer which contains Si_{1-y}Ge_{y}, where y ≤ x, and in which the germanium proportion decreases is grown by selective epitaxy between the Si₁₋ₓGeₓ layer (4) and the stressed silicon layer (5).

11. Method according to one of Claims 6 to 10,
**characterized in that**
- in order to fabricate at least one p-channel MOS transistor and an n-channel MOS transistor, gate stacks each comprising a gate dielectric (10), a gate electrode (11) and a covering layer (12) are formed on the surface of the semiconductor island (6),
- an auxiliary layer (13) is deposited with essentially conformal edge coverage,
- spacers (140) are formed in the region of the sidewalls of the gate stacks, which spacers can be etched selectively with respect to the auxiliary layer (13),
- first subregions (16, 18) of the source/drain regions for the n-channel MOS transistor and the p-channel MOS transistor are formed in each case by means of masked implantation,
- the spacers (140) are removed, and
- second subregions (20, 23) of the source/drain regions for the n-channel MOS transistor and the p-channel MOS transistor are successively formed, depth and doping concentration in each case being less than those of the first subregions (16, 18).

12. Method according to Claim 11,
**characterized in that**
at least the second subregions (23) of the source/drain regions for the p-channel MOS transistor are formed by etching at least into the stressed silicon layer (5) and selective, in-situ doped epitaxy.

13. Method according to one of Claims 6 to 12,
**characterized in that**
the gate electrodes (11) of the MOS transistors comprise polycrystalline germanium.

## Revendications

1. Circuit intégré CMOS, dans lequel
- il est disposé sur une couche (2) isolante, qui est disposée sur une plaque (1) support, des îlots (6) semi-conducteurs qui comprennent respectivement au moins une couche (4) en Si₁₋ₓGeₓ et une couche (5) en silicium et
- il est prévu un îlot (6) semi-conducteur, un transistor MOS à canal p et un transistor MOS à canal n,
**caractérisé en ce que**
- il est prévu dans le au moins un îlot (6) semi-conducteur au moins le transistor MOS à canal p et le transistor MOS à canal n,
- le transistor MOS à canal p est dans une cuvette (8) de conductivité n et le transistor MOS à canal n et dans une cuvette (7) de conductivité p disposée à côté de la cuvette (8) de conductivité n et
- la couche (5) de silicium est une couche de silicium que l'on a fait croître par épitaxie sélective sur la couche (4) en Si₁₋ₓGeₓ qui est bloquée et qui a sensiblement la même constante de réseau que la couche (4) en Si₁₋ₓGeₓ.

2. Circuit CMOS suivant la revendication 1, **caractérisé en ce qu'**il est interposé entre la couche (4) en Si₁₋ₓGeₓ et la couche (2) isolante une couche (3) en silicium.

3. Circuit CMOS suivant la revendication 2, **caractérisé en ce que**
- la couche (3) structurée en silicium a une épaisseur comprise entre 0 nm et 20 nm,
- la couche (4) en Si₁₋ₓGeₓ a une épaisseur comprise entre 10 nm et 50 nm et a une proportion de germanium comprise entre 20 % et 50 % et
- la couche (5) bloquée en silicium a une épaisseur comprise entre 5 nm et 20 nm.

4. Circuit CMOS suivant l'une des revendication 1 à 3, **caractérisé en ce qu'**il est interposé entre la couche (4) en Si₁₋ₓGeₓ et la couche (5) bloquée en silicium une couche tampon qui contient du Si_{1-y}Ge_{y} et dans laquelle la proportion de germanium diminue.

5. Circuit CMOS suivant l'une des revendication 1 à 4, **caractérisé en ce que** les électrodes (11) de grille des transistors MOS contiennent du germanium polycristallin.

6. Procédé de fabrication d'un circuit intégré CMOS, dans lequel :
- on structure sous forme d'îlot une couche (3) de silicium d'un substrat SOI, qui comprend la couche (3) de silicium et une couche (2) isolante sous-jacente sur une plaque (1) servant de support, la surface de la couche (2) isolante étant partiellement mise à nu et
- pour la formation d'îlots (6) semi-conducteurs sur la couche (3) structurée de silicium, on forme une couche (4) en Si₁₋ₓGeₓ et une couche (5) de silicium,
**caractérisé en ce que**
- on fait croître la couche (5) bloquée de silicium par épitaxie sélective sur la couche (4) en Si₁₋ₓGeₓ,
- on adapte l'épaisseur de la couche (4) en en Si₁₋ₓGeₓ à l'épaisseur de la couche (3) structurée en silicium, de façon que la constante de réseau de la couche (3) structurée en silicium s'adapte à la constante de réseau de la couche (4) en en Si₁₋ₓGeₓ,
- on forme dans un îlot (6) semi-conducteur une cuvette (7) de conductivité p et à côté de celle-ci une cuvette (8) de conductivité n et
- on forme dans la cuvette (7) de conductivité p un transistor MOS à canal n et dans la cuvette (8) de conductivité n un transistor MOS à canal p.

7. Procédé suivant la revendication 6, **caractérisé en ce que**
- on forme la couche (3) structurée en silicium en une épaisseur comprise entre 5 nm et 20 nm,
- on forme la couche (4) en en Si₁₋ₓGeₓ en une épaisseur comprise entre 10 nm et 50 nm et avec une proportion x de germanium comprise entre 20 % et 50 % et
- on forme la couche (5) bloquée de silicium en une épaisseur comprise entre 5 nm et 20 nm.

8. Procédé suivant la revendication 6 ou 7, **caractérisé en ce que** pour la formation de l'îlot (6) semi-conducteur on fait croître par épitaxie sélective la couche (4) en en Si₁₋ₓGeₓ sur la couche (3) structurée en silicium.

9. Procédé suivant la revendication 6 ou 7, **caractérisé en ce que** pour la formation des îlots (6) semi-conducteurs on introduit dans la couche (3) structurée en silicium pour la formation de la couche (4) en Si₁₋ₓGeₓ du germanium par implantation ou par diffusion.

10. Procédé suivant l'une des revendications 6 à 9, **caractérisé en ce que** l'on fait croître entre la couche (4) en en Si₁₋ₓGeₓ et la couche (5) bloquée en silicium par épitaxie sélective une couche tampon qui contient du Si_{1-y}Ge_{y} avec y ≤ x et dans laquelle la proportion de germanium diminue.

11. Procédé suivant l'une des revendications 6 à 10, **caractérisé en ce que**
- pour la fabrication d'au moins un transistor MOS à canal p et d'un transistor MOS à canal n à la surface de l'îlot (6) semi-conducteur, on forme une pile de grilles qui comprennent respectivement un diélectrique (10) de grille, une électrode (11) de grille et une couche (12) supérieure,
- on dépose une couche (13) auxiliaire à revêtement d'arête sensiblement conforme,
- on forme dans la zone des flancs de la pile de grilles des espaceurs (140) qui peuvent être attaqués sélectivement par rapport à la couche (13) auxiliaire,
- on forme respectivement par implantations masquées de premières sous-zones (16, 18) des zones source/drain pour le transistor MOS à canal n et pour le transistor MOS à canal p,
- on élimine les espaceurs (140) et
- on forme successivement deux sous-zones (20, 23) des zones source/drain pour le transistor MOS à canal n et pour le transistor MOS à canal p, tandis que la profondeur et la concentration de dopage sont respectivement plus petites que celles des premières sous-zones (16, 18).

12. Procédé suivant la revendication 11, **caractérisé en ce que** l'on forme au moins les deuxièmes sous-zones (23) des zones source/drain pour le transistor MOS à canal p par attaque au moins dans la couche (5) bloquée de silicium et par épitaxie sélective et dopée in situ.

13. Procédé suivant l'une des revendications 6 à 12, **caractérisé en ce que** les électrodes (11) de grille des transistors MOS comprennent du germanium polycristallin.
